# EUROPÄISCHE PATENTSCHRIFT

(11) **EP 2 681 980 B1**
(45) Veröffentlichungstag und Bekanntmachung des Hinweises auf die Patenterteilung: **30.03.2016**
(21) Anmeldenummer: 12708653.6
(22) Anmeldetag: 20.01.2012
(51) Int. Cl.: H05K 7/20

(54) **ELEKTRISCHE EINRICHTUNG MIT EINER KÜHLEINRICHTUNG**
ELECTRICAL DEVICE COMPRISING A COOLING DEVICE
DISPOSITIF ÉLECTRIQUE COMPRENANT UN DISPOSITIF DE REFROIDISSEMENT

(30) Priorität: 03.03.2011 DE 102011012948; 31.03.2011 DE 102011015756
(43) Veröffentlichungstag der Anmeldung: 08.01.2014
(73) Patentinhaber: MAUL, Martin, 36129 Gersfeld (Rhön) (DE)
(72) Erfinder: MAUL, Martin, 36129 Gersfeld (Rhön) (DE)
(74) Vertreter: Sawodny, Michael-Wolfgang
(86) Internationale Anmeldenummer: PCT/EP2012/000254
(87) Internationale Veröffentlichungsnummer: WO 2012/116768

(56) Entgegenhaltungen:
- DE-U1-202005 016 960
- US-A- 5 896 922
- US-A1- 2009 080 173
- US-B1- 6 205 796

## Beschreibung

Die Erfindung betrifft eine elektrische Einrichtung mit zwei Computeranlagen und mit einer Kühleinrichtung, insbesondere einer Klimatisierungseinrichtung, wobei die Computeranlagen in einem geschlossenen Raum untergebracht sind und die Kühleinrichtung wenigstens einen Verdampfer, einen Verdichter und einen Verflüssiger umfasst. Die Computeranlagen erzeugen bei ihrem Betrieb Wärme.

Computeranlagen sind in der Regel in einem Gestell, insbesondere einem 19"- rack oder einem Schalt- oder Steuerschrank untergebracht. Die Schalt- oder Steuerschränke enthalten Kühlanlagen beziehungsweise Klimageräte, die dem Zweck dienen, die Luft im Schaltschrank umzuwälzen, um dabei abzukühlen. Die gesamte Kühlanlage gemäß dem Stand der Technik wird beispielsweise in der Frontwand beziehungsweise Tür oder einer Seitenwand oder im Sockel eingebaut. Beispielhafte Schriften, die Schaltschränke zeigen sind die nachfolgend:
DE 34 36 407
US 5 467 250
DE 196 01 456
DE 35 04 207
DE 88 10 228
EP 1 026 932

Die DE 34 36 407 zeigt ein Klimagerät, dass in den Innenraum eines Schaltschrankes eingeschoben werden kann.

Aus der US 5,467,250 ist ein Schaltschrank bekanntgeworden, bei dem ein Wärmetauscher in die Schaltschranktür eingebaut ist.

Die DE 196 01 456 zeigt einen klimatisierten Schaltschrank mit in die Tür und/oder in ein Wandelement integriertes Klimagerät oder Wärmetauscher, wobei das Wandelement oder die Schranktür als Gehäuse zur Aufnahme der Komponenten des Klimagerätes und/oder des Wärmetauschers ausgebildet sind.

Es ist auch bekannt, ein Klimagerät auf der Außenseite einer Schaltschrankwand anzubringen. Eine derartige Anordnung zeigt die DE 35 04 207 oder auch die DE 88 10 228.

Die EP 1 026 932 zeigt ein Schaltschranksystem, dass als modulares System aufgebaut ist und durch Anbringen unterschiedlicher Kühl- oder Klimamodule auf vorbestehenden Montagebereiche des Schaltschrankes unterschiedliche Kühlsysteme ermöglicht zu realisieren.

Die EP 1 026 932 ermöglicht es, je nach Bedarf Kühl- oder Klimamodule unterschiedlicher Kapazitäten und unterschiedlicher Technologien auf den Schrankkorpus als einem ersten Modul in einem vorbereiteten Montagebereich aufzusetzen.

Die US 6,205,796 zeigt einen redundanten Feuchtigkeitskontrollmechanismus, der auf eine Temperatur unterhalb des Taupunktes der Umgebung gekühlt wird. Die in der US 6,205,796 gezeigte Apparatur umfasst eine Kühlplatte mit zwei Verrohrungen für Kühlmittel.

Die US 5,896,922 zeigt eine Kühlplatte mit zwei isolierten Kühlkreisläufen für Kühlmittel.

Aus der US 2009/0080173 A1 ist eine Kühleinrichtung für eine Computeranlage bekannt geworden.

Die DE 20 2005 016960 zeigt ein Kühlgerät bzw. ein Kühlgerätgehäuse, insbesondere zur Kühlung von Computerracks.

Aus dem nächstliegenden Stand der Technik in Form der WO 2009/141610 A ist eine Computeranlage mit einer Kühleinrichtung bekanntgeworden, wobei die Computeranlage in einem geschlossenen bzw. umschlossenen Raum untergebracht ist und einen Wärmetauscher umfasst. Des Weiteren weist der Wärmetauscher Verbinder zum Anschließen an eine externe Kühlwasserversorgung auf und der Wärmetauscher ist in einem einzigen Gehäuse ausgeführt. Der Wärmetauscher ist als einzeln stehender Wärmetauscher zwischen zwei zu kühlenden Computeranlagen angeordnet und Luft wird über eine stirnseitige Seitenwand des Gehäuses angesaugt, im Wärmetauscher gekühlt und über die Öffnungen und Leiteinrichtungen in den Seitenwänden zur jeweiligen Computeranlage gefördert.

Nachteilig an all den zuvor beschriebenen Systemen, bei dem die Kühlung direkt im Schaltschrank erfolgte, war, dass die Wärme aus dem geschlossenen Raum nicht abgeführt wurde, sondern lediglich der Schaltschrank wurde gekühlt und die bei der Kühlung anfallende Wärme, insbesondere die Wärme des Verdichters und Verflüssigers, in den geschlossenen Raum abgegeben. Hierdurch wurde der geschlossene Raum aufgeheizt, und es musste zusätzliche Kühlenergie für den Verdampfer aufgewandt werden. Ein weiterer Nachteil lag darin, dass als Kältemittel in der Regel Wasser eingesetzt wurde, was insbesondere bei Undichtigkeit dazu führte, dass flüssiges Kühlmittel in elektrische Einrichtungen eindrang, wodurch in der elektrischen Komponente, beispielsweise in den Computern Kurzschlüsse entstanden. Ein weiteres Problem bestand darin, dass die Kühlsysteme als Einzelkühlsysteme ausgelegt waren, was bedeutete, dass bei Ausfall des Kühlsystems die Computeranlage ungekühlt war, was wiederum zu einer Abschaltung der Computeranlagen bzw. der elektrischen Einrichtung führte, wenn ein einzelnes Kühlsystem ausfiel.

Aufgabe der Erfindung ist es somit, den Nachteil des Standes der Technik zu vermeiden, insbesondere eine elektrische Einrichtung mit einer Kühleinrichtung anzugeben, mit der es möglich ist, sicher eine elektrische Einrichtung zu kühlen. Des Weiteren soll die Kühleinrichtung in einem geschlossenen Raum untergebracht werden können und insbesondere ein Ausfall der Kühleinrichtung vermieden werden.

Erfindungsgemäß wird die Aufgabe durch eine elektrische Einrichtung mit zwei Computeranlagen und mit einer Kühleinrichtung, insbesondere einer Klimatisierungseinrichtung gemäß Anspruch 1 gelöst.

Die Computeranlage, ist in einem geschlossenen Raum untergebracht und die Kühleinrichtung weist wenigstens einen Verdampfer, einen Verdichter und einen Verflüssiger auf. Die Kühleinrichtung ist dadurch gekennzeichnet, dass der Verdichter und der Verflüssiger außerhalb des geschlossenen Raumes angeordnet ist und der Verdampfer innerhalb des geschlossenen Raumes und der Verdampfer in einer redundanten Bauform ausgeführt ist, bevorzugt in einem einzigen Gehäuse. Bei der Ausführung des Verdampfers in redundanter Bauform in einem Gehäuse ist beispielsweise ein Verdampferblock mit wenigstens zwei Eingangs- und zwei Ausgangsanschlüssen versehen, wobei je ein Eingangs- und ein Ausgangsanschluss mit einem Kältekreislauf, bevorzugt je einem eigenen Kältekreislauf verbunden ist. Der Verdampferblock umfasst wenigstens zwei voneinander getrennte Verrohrungen von der jeweiligen Eingangsseite zur jeweiligen Ausgangsseite. Fällte ein Teil des Verdampfers, beispielsweise eine der über Lamellen geführten Verrohrung beispielsweise wegen Übertemperatur aus, so kann beispielsweise durch Schalten eines Ventils sofort die andere, getrennt ausgebildete Verrohrung des Verdampfers und damit der andere Teil des Verdampfers aktiviert werden. Auf diese Art und Weise wird dann die erfindungsgemäße Redundanz des Verdampfers zur Verfügung gestellt. Durch die Ausgestaltung des Verdampfers in redundanter Bauweise, bei der in einem einzigen Verdampferblock zwei Verrohrungen für zwei getrennte Kühlkreisläufe untergebracht sind, können gegenüber einer Bauweise mit zwei getrennten einzelnen Verdampfern in unterschiedlichen Einzelgehäusen erhebliche Materialersparnisse und Fertigungsvereinfachungen erzielt werden.

Der Verdampfer, der im Inneren des geschlossenen Raumes angeordnet ist, ist so aufgestellt, dass eine sehr genaue Luftführung zu dem elektrische Bauelement, zur Verfügung gestellt wird.

Des Weiteren ist der Verdampfer bevorzugt als Seitenwandverdampfer ausgestaltet. Der Verdampfer umfasst des Weiteren eine Kondensatwanne und Abschlussbleche, insbesondere aus Aluminium zur vollständigen Kondensatfassung. Insbesondere ist der Verdampfer ein Hochleistungskälteverdampfer mit aufgepressten Aluminiumlamellen, der über einen hohen Wirkungsgrad verfügt. Der Verdampfer verfügt über einen selbsttragenden Aluminiumrahmen und Kupferkernrohre. Im Normalkühlfall ist keine Entfeuchtung notwendig. Eine saugseitige Anordnung der Lüfter sorgt für optimale Anström- und Durchströmbedingungen und geringste Druckverluste.

Bevorzugt ist der Verdampfer als einzeln zu stellendes Bauteil umfassend ein einzeln zu stellendes Gehäuse, das wenigstens den Verdampferblock umfasst, ausgebildet.

Das Gehäuse umfasst bevorzugt Seitenwände mit Lüftungsschlitzen und Leitblenden. Die gekühlte Luft wird dann beispielsweise über die Seitenwände an neben den Seitenwänden stehenden Computeranlagen, die bevorzugt wiederum in Schaltschränken angeordnet sind, abgegeben. Zusätzlich können an der Stirnseiten des Gehäuses des Verdampfers Lüfter angeordnet sein, die es ermöglichen zusätzlich zu den Computeranlagen auch den umschlossenen Raum zu kühlen, da sie die kalte Luft nicht in die Computeranlage, sondern in den Raum abgeben.

Das Gehäuse des Verdampfers ist zwischen zwei Computerschränken angeordnet und je eine Seitenwand des Verdampfers benachbart zu einer Wand eines Computerschrankes.

Verdichter und Verflüssiger sind erfindungsgemäß außerhalb des geschlossenen Raumes angeordnet. Verflüssiger und Verdichter bilden gemeinsam ein Außengerät, das außerhalb des geschlossenen Raumes angeordnet und daher wetterfest ausgelegt ist. Bevorzugt wird das Außengerät luftgekühlt und ist beispielsweise für das Kältemittel R410a, R 407c und R134a ausgelegt. Bevorzugt wird das Außengerät umfassend den Verdichter und den Verflüssiger auf Grundlage der Drehzahlregelung realisiert. Die Auslegung des Außengerätes umfassend Verflüssiger und Verdichter auf Grundlage der Drehzahlregelung ermöglicht eine bedarfsabhängige Drehzahlregulierung des Verdichters. Die Kältemittelmenge wird dann über das elektronische Expansionsventil geregelt und ermöglicht eine Energieeinsparung von bis zu 50%.

Die Energieeinsparung wird dadurch erreicht, dass die Drehzahl des Verdichters in Abhängigkeit der von der Computeranlage und/oder dem umschlossenen Raum benötigten Kühlleistung beispielsweise zum Einhalten von Temperaturgrenzen eingestellt wird, d. h. es wird nur die benötigte Kalkleistung zugeführt.

Der Verflüssiger gemäß einer vorteilhaften Ausführungsform der Erfindung umfasst bevorzugt wenigstens zwei Kältekreisläufe. Der Verflüssiger umfasst in einer bevorzugten Ausführungsform des Weiteren einen Axialventilator bevorzugt mit Korbgitterkonsole in korrosionsgeschützter wasserfester Ausführung, einen Wärmetauscher, bevorzugt aus Kupfer (Cu)-Kemrohren mit aufgepressten Aluminiumlamellen sowie einen Drehzahlregler in der Kondensatleitung, der den Axialventilator steuert. Der Verflüssiger umfasst des Weiteren bevorzugt ein korrosionsfestes selbsttragendes Gehäuse, insbesondere aus Aluminium.

Der Verdichter des Außengerätes kann bevorzugt als Doppelrollkolbenverdichter oder als Scroll-Kompressor bevorzugt schallgedämpft ausgeführt sein. Doppelrollkolbenverdichter oder der Scroll-Kompressor weist einen sehr geringen Stromverbrauch bei einer sehr großen Leistung auf. Um dies zu erreichen kann beispielsweise der Scroll-Kompressor eine Drehzahlregelung aufweisen, die zu einer sanften und gleichmäßigen Verdichtung bei geringem Geräuschpegel und geringen Schwingungen im Betrieb führt. Des Weiteren sind eine Sauggaskühlung, ein interner Motorschutz sowie ein internes Ölmanagement vorgesehen.

In einer bevorzugten Ausführungsform kann die vom Verdampfer gekühlte Luft über einen Wärmetauscher am elektrischen Bauelement zur Verfügung gestellt werden.

Besonders bevorzugt umfasst die Kühleinrichtung wenigstens zwei geschlossene, getrennte Kältekreisläufe mit Verdichter, Verflüssiger und Verdampfer.

Besonders bevorzugt ist die Kühleinrichtung mit einer Regel- und/oder Steuereinrichtung bevorzugt in Form eines Mikroprozessors versehen. Eine derartige Ausgestaltung ermöglicht es, in Abhängigkeit eines oder mehreren der nachfolgenden Steuer- bzw. Regelgrößen
- Raumtemperatur im geschlossenen Raum
- Außentemperatur außerhalb des geschlossenen Raumes
- Betriebszustand der Computeranlage, insbesondere Stromaufnahme der Computeranlage, Leistungsaufnahme der Computeranlage
eine oder mehrere der nachfolgenden Einrichtung
- Kühleinrichtung und/oder
- Verdampfer und/oder
- Gebläse und/oder
- Verdichter und/oder
- Ventilator
zu steuern und/oder zu regeln.

Durch die Regelung lässt sich ein hoher Energiebetrag einsparen wie zuvor dargestellt.

Der im Innenraum beziehungsweise im geschlossenen Raum angeordnete Verdampfer, umfasst um bei einem Ausfall eines Elementes die Kühlung weiter zu gewährleisten in redundanter Bauweise zwei geschlossene, getrennte Kältekreisläufe, die in ein gemeinsames Gehäuse integriert sind. Bevorzugt umfasst der Verdampfer in redundanter Bauweise ein Verdampferblock mit getrennten Verrohrungen für jeden Kältekreis.

Bevorzugt handelt es sich bei dem Verdampfer in redundanter Ausführung um einen Seitenwandverdampfer, der die gekühlte Luft direkt in die Computeranlage und/oder den umschlossenen Raum abgibt,mit folgenden Daten:

| | |
|---|---|
| Gerätetyp: | Seitenkühler RDCU |
| Kälteleistung regelbar: | 5 bis 35 kW |
| Kondensationstemperatur: | 45°C |
| Verdampfungstemperatur: | 10°C |
| EER: | 4,07kW |
| LpA (10m Freifeld): | 35-45 dB(A) |
| Luftmenge: | 4000-4500m³ |
| Rücklufttemperatur: | 24°C |
| Rückluftfeuchte: | 50 rel. % |
| Zuluftfeuchte: | 13°C |
| Höhe über NN: | 0m |
| Höhe: | 2000mm bis 2200mm |
| Breite: | 300mm bis 400mm |
| Tiefe: | 1000mm bis 1200mm |
| Gewicht: | 310kg |
| Kältemittel: | R410a |
| Frequenz: | 50Hz |

Der bei dem oben genannten Seitenwandverdampfer in redundanter Bauweise verbaute Verdampferblock mit zwei getrennten Verrohrungen weist folgende Daten auf:

| Verdampferblock | | BAT F/10+8/5/3.00/1610/AXG/ /051040 | | | | | |
|---|---|---|---|---|---|---|---|
| Leistung: | | 32.2 KW | | Einbau in: | | Gehäuse | |
| Fläche: | | 63.5m² | | Anschlüsse: | | rechts | |
| Flächenreserve: | | 0.4% | | Rohranordnung: | | versetzt | |
| Kondensat: | | 14.86 kg/h | | Reifdicke: | | 0.0 mm | |
| | | | | | | | |

| Luft | Eintritt | | Austritt | | Kältemittel: | | R410A |
|---|---|---|---|---|---|---|---|
| Volumenstrom: | 4240 m³/h | | 4000 m³/h | | Verdampfungstem.: | | 5.0°C |
| Temperatur: | 25.0 °C | | 9.5°C | | Überhitzung: | | 5.0 K |
| Rel. Luftfeuchte: | 49% | | 90 % | | Kondensationstemp.: | | 50.0 °C |
| Geschwindigkeit: | 2.8 m/s | | | | Unterkühlungstemp.: | | 49.0°C |
| Druckverlust | 300 Pa | | | | Druckverlust: | | 0.012 bar / 0.04 K |
| Rohrinhalt: | 10.0 l | | | WT-Rohre: | | | Kupfer |
| Lam. Teilung: | 3.00 mm | | | Verteiler: | | | Messing |
| Leergewicht: | 48.3 kg | | | Spinne: | | | Kupfer |
| Lamellierte Länge: | 1610 mm | | | Lamellen: | | | Aluminium |
| Lamellierte Höhe | 250 mm | | | Kollektor: | | | Kupfer |
| Einbaulänge: | | | | Rahmen: | | | AlMg3 |
| Rahmenlänge: | | | | Kreise: | | | 1N |
| Rahmenhöhe: | | | | Pässe: | | | 2 |
| Rahmentiefe: | | | | Stränge: | | | 25 |
| Rohrreihen Tiefe: | 10+8 | | | Tragrohre: | | | 0 |
| Max. Betriebsdruck: | 41.0 bar | | | Kapillare: | | | 4.0*0.75 mm |
| Eintrittsstutzen: | 22.0 mm | | | Länge: | | | 450 mm |
| Sammelrohr: | 28.0*1.50 mm | | | Vert.-Dp: | | | 2.0 bar |
| Saugstutzen: | 35.0*1.50 mm | | | Anteil:-Dp: | | | 9% |

Die verbauten Axialventilatoren sind bevorzugt mit nachfolgenden Spezifikationen ausgeführt:

| | |
|---|---|
| Ventilatortyp: | R3G560_AH02_08 |
| Anzahl | 6 |
| Maximal Drehzahl: | 2770 U/min |
| Drehzahl: | 2450 U/min |
| Aufnahmeleistung: | 0,29 kW |
| P Gesamt: | 250 Pa |
| Steuerspannung: | 230 V |
| Motorwirkungsgrad: | 89% |

Die Erfindung soll nachfolgend anhand der Figuren beispielhaft beschrieben werden:

Es zeigen:
- Fig. 1a: den prinzipiellen Aufbau
- Fig. 1b: Anordnung des Verdampfers zwischen Computeranlagen
- Fig. 2: den prinzipiellen Aufbau eines in Fig. 1 verwandten Verdampfers im Schnitt
- Fig. 3a - 3c: den Aufbau des Verdampferblocks in redundanter Bauweise

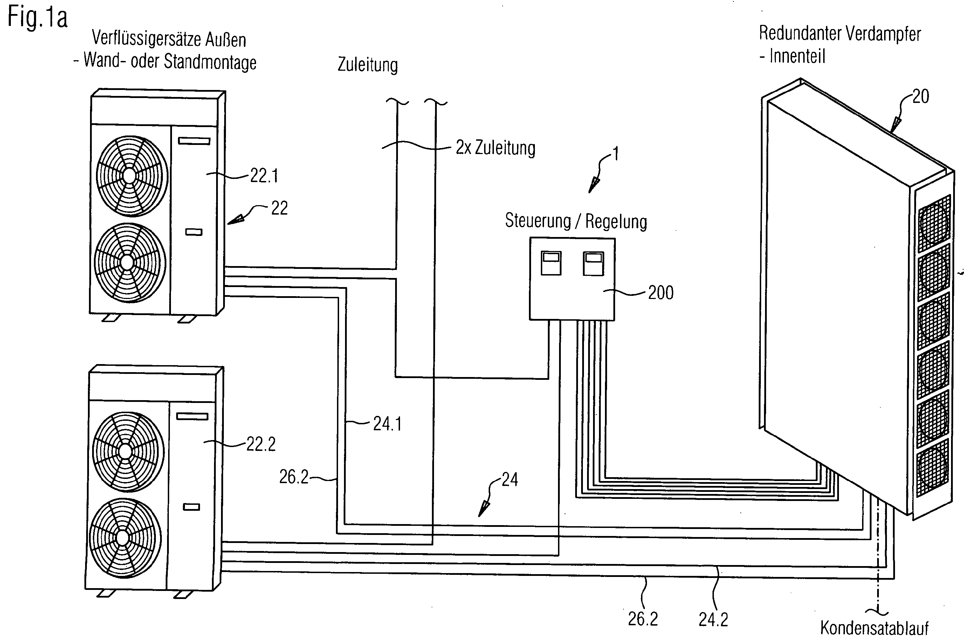

In Fig. 1a ist der prinzipielle Aufbau der erfindungsgemäßen elektrischen Einrichtung mit einer Kühleinrichtung 1, insbesondere zwei Computeranlagen (nicht gezeigt), die in einem umschlossenen Raum 5 angeordnet sind, dargestellt. Die Computeranlage kann in einem Gestell 7, das als Rack zur Aufnahme von elektrischen Bauelementen, insbesondere Computern ausgebildet ist angeordnet sein. Die Unterbringung in einem Rack ist vorteilhaft, aber keineswegs zwingend für die Erfindung. Die Kühleinrichtung 1 umfasst einen Verdampfer 20 sowie eine Außenkühleinrichtung 22, die außerhalb des umschlossenen Raumes 5 angeordnet ist. Die Außenkühleinrichtung 22 umfasst einen Verdichter und einen Verflüssiger (nicht dargestellt). In der Kühleinrichtung wird ein Kältemittel umgewälzt, das zunächst in dem Außengerät 22 verdichtet wird. Das verdichtende Kältemittel wird von der Außenkühleinrichtung 22 über Leitung 24 zum Verdampfer 20 gefördert. Im vorliegenden Ausführungsbeispiel ist die gesamte Kühleinrichtung 1 redundant ausgeführt und umfasst daher zwei getrennte Kühlkreisläufe, wobei jeder Kühlkreislauf eine eigene Außenkühleinrichtung 22.1, 22.2 aufweist, sowie eine eigene Zuleitung 24.1, 24.2 zum Verdampfer 20 und eigene Ableitungen 26.1, 26.2 vom Verdampfer. Der Verdampfer 20 selbst ist auch redundant ausgeführt und weist einen Verdampferblock mit zwei unabhängigen getrennten Verrohrungen ergebend jeweils ein Teilverdampfer auf, wobei jeder Teilverdampfer je einem der zwei getrennten Kühlkreisläufe zu geordnet ist.

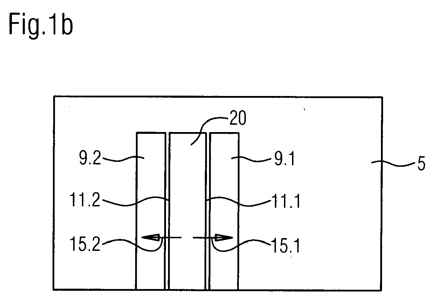

Es wäre aber auch denkbar nicht die gesamte Kühlanlage redundant mit zwei Kühlkreisläufen auszuführen, sondern nur den Verdampfer mit zwei Teilverdampfern. Diese nicht dargestellte Ausführungsform würde nur ein Außenkühlgerät 22 umfassen und einen Kühlkreislauf, der aber im Verdampfer 20 bei redundanter Ausführung des Verdampfers in zwei Teilkreisläufe aufgespalten wird, wobei de Teilkreisläufe durch ein Schaltventil in den gesamten Kühlkreislauf der Kühleinrichtung geschaltet werden. Fällt bei einer derartigen Kühleinrichtung ein Teilverdampfer aus, so wird das Schaltventil betätigt und der andere Teilverdampfer in den Kühlkreislauf geschaltet. Diese Ausführungsform weist zwar nicht die hohe Ausfallsicherheit einer Anlage mit zwei Außenkühlgeräten und zwei vollständig getrennten Kühlkreisläufen wie die in Fig. 1 dargestellte Ausführungsform auf, aber Redundanz im Bereich des Verdampfers. Denkbar, obwohl nicht gezeigt, sind Kühlanlagen mit mehr als zwei Kühlkreisläufen.

Generell ist die Funktionsweise der Kälteeinrichtung so, dass sich im Verdampfer 20 das Kältemittel entspannt. Durch die Entspannung des Kältemittels entsteht eine Abkühlung aufgrund des Joule Thompson Effekts. Das entspannte abgekühlte Gas wird über Ableitung 26.1, 26.2 zum Verdichter geleitet, erneut verdichtet und wieder zum Verdampfer 20, wo es sich wieder unter Erzeugung von Kälte entspannt Die Kälteerzeugung mittels einer Kompressionskältemaschine ist dem Fachmann hinreichend bekannt. Diesbezüglich wird beispielsweise auf das Lehrbuch Gerthsen-Kneser-Vogel; "Physik", 13. Auflage, S. 221-224, verwiesen. Bei der dargestellten Ausführungsform ist wie beschrieben der gesamte Kältekreislauf redundant ausgeführt d. h. es liegen wenigstens zwei geschlossene Kältekreise vor.

Wie ausführlich zuvor beschrieben, ist der Verdampfer erfindungsgemäß in sich selbst redundant ausgeführt, d. h. er hat im Gegensatz zum Stand der Technik in einem Gehäuse wenigstens zwei unabhängige, getrennte Verrohrungen bevorzugt in einem Verdampferblock. Bevorzugt Ist der Verdampfer in redundanter Ausführung als Seitenwandverdampfer ausgebildet, d. h. die gekühlte Luft wird über eine oder beide Seitenwände dem elektrischen Bauelement beziehungsweise den Computeranlagen zur Verfügung gestellt. In der Seitenwand können Luftleitbleche vorgesehen sein, die die gekühlte Luft zu dem elektrischen Bauelement leiten. Die gekühlte Luft strömt dann am elektrischen Bauelement vorbei und wird hierbei erwärmt. Hierdurch wird wiederum das elektrische Bauelement gekühlt.

Der geschlossene Raum wird bei der Ausführung mit Außenkühlanlage lediglich durch die Abwärme der Computeranlage erwärmt, nicht jedoch durch die Wärme, die beim Verdichten des Kältemittels entsteht, da der Verdichter erfindungsgemäß in einer Außenkühlanlage 22 angeordnet ist. Auf diese Art und Weise wird der geschlossene Raum erheblich vom Wärmeeintrag entlastet, im Gegensatz zu Geräten, bei denen die Klimaeinrichtung mit all ihren Bauelementen wie beispielsweise in der EP 1 026 932 beschrieben in dem Schaltschrank beziehungsweise dem Gestell beziehungsweise Rack angeordnet sind.

In Figur 1b ist eine mögliche Aufstellung des Verdampfers 20 zwischen zwei Computeranlagen 9.1, 9.2 als einzeln stehender Verdampfer 20 in redundanter Ausführung in einem umschlossenen Raum 5 in einer Draufsicht gezeigt. Die Computeranlagen 9.1, 9.2 sind bevorzugt in einem eigenen Schaltschrank beziehungsweise Rack untergebracht. Der Schaltschrank beziehungsweise das Rack der Computeranlage 9.1, 9.2, ist benachbart zu den Seitenwänden 11.1, 11.2 des Verdampfers 20 angeordnet. Luft wird über eine erste stirnseitige Seitenwand 13.1 des Verdampfers angesaugt, im Verdampfer 20 gekühlt und über Seitenwandöffnungen und Leiteinrichtungen wie mit Pfeilen 15.1, 15.2 angedeutet in die jeweilige Computeranlage 9.1, 9.2 gefördert. Auf der der ersten stirnseitigen Seitenwand 13.1 gegenüberliegenden Seitenwand 13.2 wird die angesaugte Luft in den Raum 5 abgegeben, so dass mit dem Verdampfer 22 auch der Raum 5 gekühlt wird.

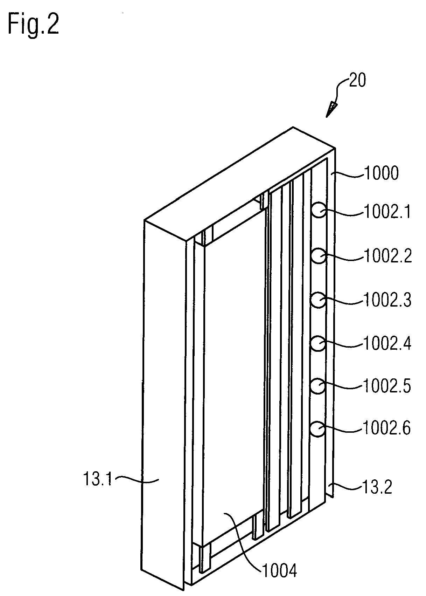

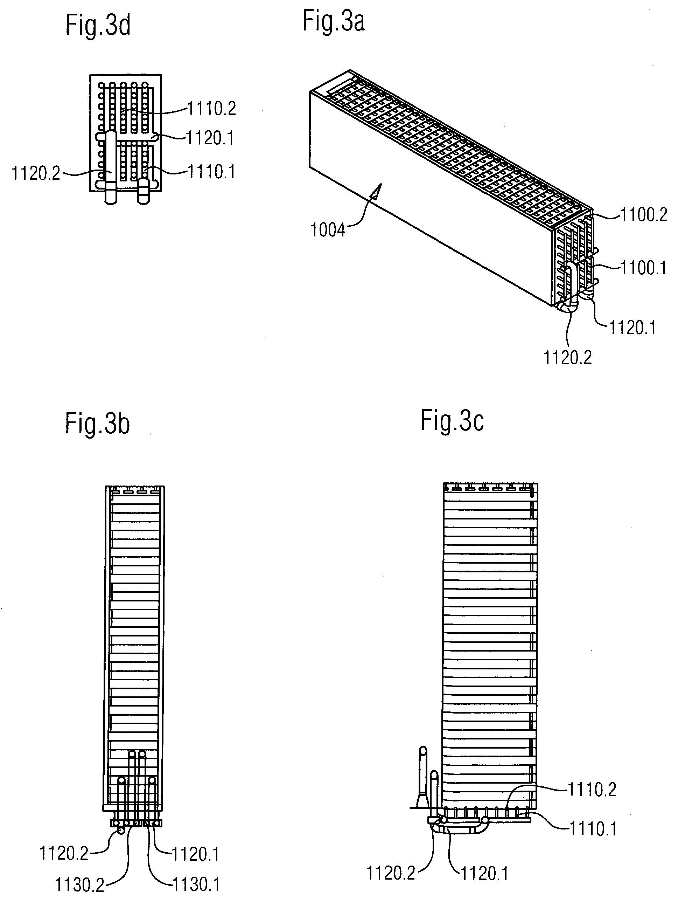

In Figur 2 ist der Verdampfer 20 im Schnitt nochmals detailliert dargestellt. Der Verdampfer 20 weist in der dargestellten Ausführungsform ohne hierauf beschränkt zu sein, eine Kälteleistung von 35kW auf und ist redundant ausgeführt, d. h. er verfügt über 2 redundant miteinander verschaltete Teilverdampfer, die in ein und dasselbe Gehäuse eingebaut sind, aber jeweils einzelne, getrennte Verrohrungen aufweist. Die Verrohrung des Verdampfers 20 kann insbesondere den Fig. 3a-3d entnommen werden. Fig. 2 zeigt insbesondere das gemeinsame Gehäuse 1000 des Verdampfers 20. Im gemeinsamen Gehäuse 1000 sind an der vorderen, ersten stirnseitigen Seitenwand 13.1 Öffnungen zum Ansaugen von gasförmigen Medium, insbesondere Luft vorgesehen. Das Ansaugen von Luft wird insbesondere mittels von Lüftern - in der vorliegenden Ausführungsform sechs Lüftern 1002.1, 1002.2, 1002.3 1002.4, 1002.5, 1002.6 - bewerkstelligt, die hinter der der ersten Seitenwand gegenüberliegenden Seitenwand 13.2 angeordnet sind. Die Kühlung der angesaugten Luft wird durch einen Verdampferblock 1004, der zwei Teilverdampfer mit getrennten Verrohrungen umfasst, zur Verfügung gestellt. Die zur Kühlung der elektrischen Einrichtungen benötigte gekühlte Luft wird über Öffnungen in den Seitenwänden, die vorliegende nicht gezeigt sind, zur Verfügung gestellt.

Die Einzelheiten des Verdampferblockes 1004 in der redundanten Ausführungsform sind detailliert in den Figuren 3a-3d gezeigt.

Figur 3a zeigt eine dreidimensionale Ansicht eines Verdampferblockes 1004. Der Verdampferblock 1004 umfasst zwei nebeneinander liegende, getrennte Verrohrungen 1100.1, 1100.2, die jeweils ein Teilverdampfer mit eigenem Kühlkreislauf ausbilden, so dass der Verdampferblock redundant ausgebildet ist. Hierfür ist jeder Teilverdampfer mit einer eigenen Zuleitung und einer eigenen Ableitung für das Kühlmittel ausgestattet. Dies ist deutlich in der Seitenansicht gemäß Figur 3c und der Stirnansicht in Figur 3b gezeigt. In Figur 3c ist wie in Figur 3a und 3b die Zuleitung mit 1120.1 zur ersten Verrohrung 1100.1 ausbildend den ersten Teilverdampfer und mit 1120.2 zur zweiten Verrohrung 1100.2 ausbildend den zweiten Tellverdampfer gezeigt. Die Ableitung bzw. Rückleitung 1130,1, 1130.2 von erstem Teilverdampfer bzw. zweitem Teilverdampfer ist in Fig. 3b gezeigt. In der Seitenansicht gemäß Fig. 3c sind nur die Zuleitungen 1120.1 zur ersten Verrohrung 1110.1 beziehungsweise zweiten Verrohrung 1110.2 gezeigt. Fig. 3d ist eine Ansicht von unten mit erster Zuleitung 1120.1 und zweiter Zuleitung 1120.2.

Neben dem Verdampfer umfasst die Kühleinrichtung 1 ein Außengerät 22, das in ein wetterfestes Gehäuse umfasst. Das Außengerät 22 (in Figur 1 a) ist für den Einsatz des Kältemittels R410a, R407c und R134a ausgelegt mit einer speziellen Drehzahltechnologie, durch die die Betriebskosten erheblich reduziert werden können, da sie eine bedarfsgerechte Drehzahlregelung des Verdichters ermöglichen, bevorzugt in Abhängigkeit von Meßgrößen, wie Innentemperatur und/oder Außentemperatur mit Hilfe einer Regelung. Als Verdichter kommt bei dem Außengerät beispielsweise ein schallgedämpfter Doppelrollkolbenverdichter zum Einsatz. Des Weiteren umfasst das Außenkühlgerät 22 (in Figur 1a) einen Verflüssiger, der zur Verflüssigung des Kältemittels R410a luftgekühlt ist. Der Verflüssiger besteht aus einem Kupferrohr mit leistungsstarken Aluminiumrippen 152. Der luftgekühlte Verflüssiger lässt sich leicht reinigen, ohne dass Gehäuseteile abmontiert werden müssen. Zum Abführen der Wärme aus dem Verflüssiger beziehungsweise Verdichter umfasst das Außengerät 22 einen Axialventilator aus wärmebeständigem Kunststoff. Hierdurch wird erreicht, dass Schwingungsgeräusche nur in geringem Maße auftreten können. Durch das Kunststoffspritzgussverfahren zur Herstellung Axialventilators aus wärmebeständigem Kunststoff kann eine ideale Profilierung erreicht werden, um eine möglichst lineare und konstante Strömung durch den Ventilator zu erzielen.

Besonders bevorzugt ist es, wenn die erfindungsgemäße Einrichtung eine Regeleinrichtung, die in Fig. 1a mit 200 bezeichnet ist umfasst. Mit Hilfe von Sensoren wird zum Beispiel die Temperatur der Luft im geschlossenen Raum 5 oder der Betriebszustand der Computeranlage 9.1, 9.2 bestimmt. Dieses Messsignal wird dann an die Steuer-/Regeleinrichtung 200 übermittelt. In Abhängigkeit von diesen Steuer- bzw. Regelgrößen wird dann das Außengerät 22 mit Verdichter bzw. Verflüssiger und/oder der Verdampfer 20 angesteuert, insbesondere die Drehzahl des Verdichters im Außengerät geregelt. Durch die Regelung beziehungsweise Steuerung mit Hilfe der Regel-, Steuereinrichtung kann die Kühlanlage sehr energiesparend betrieben werden. Des Weiteren können Betriebszustände sicher diagnostiziert und ein Testbetrieb durchgeführt werden.

Mit der Erfindung wird insbesondere erstmals ein Verdampfer in redundanter Bauweise, der einem Gehäuse untergebracht ist im Leistungsbereich 5-100 kW, bevorzugt 5-50 kW insbesondere für eine Kühleinrichtung, insbesondere eine Klimatisierungseinrichtung angegeben, so dass ohne Unterbrechung eine Kühlung von in einem geschlossenen Raum aufgestellten elektrischen Einrichtungen, insbesondere Computeranlagen sichergestellt wird. Durch die Unterbringung in einem Gehäuse kann erheblich Material und insbesondere auch Kosten eingespart werden.

## Patentansprüche

1. Elektrische Einrichtung mit zwei Computeranlagen (9.1 9.2) und mit einer Kühleinrichtung, insbesondere einer Klimatisierungseinrichtung, wobei die Computeranlagen (9.1, 9.2) in einem geschlossenen bzw. umschlossenen Raum (5) untergebracht sind und die Kühleinrichtung wenigstens einen Verdampfer (20), bevorzugt ein Seitenwandverdampfer, einen Verdichter und einen Verflüssiger umfasst; und
der Verdichter und der Verflüssiger außerhalb des geschlossenen bzw. umschlossenen Raumes bevorzugt in einem Außengerät (22, 22.1, 22.2) angeordnet ist
**dadurch gekennzeichnet, dass**
- die Kühleinrichtung wenigstens zwei getrennte, geschlossene Kühlkreisläufe mit getrennten Zuleitungen (24.1, 24.2) zum Verdampfer (20) und eigene Ableitungen (26.1, 26.2) vom Verdampfer aufweist;
- der Verdampfer (20) in einer redundanten Bauform in einem einzigen Gehäuse (1000) ausgeführt ist und einen einzigen Verdampferblock (1004) mit getrennten Verrohrungen (1100.1, 1100.2) aufweist, ergebend jeweils einen Teilverdampfer, wobei jeder Teilverdampfer je einem der zwei getrennten Kühlkreisläufe zugeordnet ist;
- die wenigstens zwei Teilverdampfer in einem Gehäuse (1000) untergebracht sind, wobei Öffnungen in den Seitenwänden (11.1, 11.2) des Gehäuses (1000) ausgebildet sind;
- wobei der Verdampfer (20) als einzeln stehender Verdampfer zwischen den zwei zu kühlenden Computeranlagen (9.1, 9.2) angeordnet ist und Luft über eine stirnseitige Seitenwand (13.1) des Gehäuses (20) angesaugt, im Verdampfer (20) gekühlt und über die Öffnungen und Leiteinrichtungen in den Seitenwänden zur jeweiligen Computeranlage (9.1, 9.2) gefördert wird.

2. Elektrische Einrichtung nach Anspruch 1,
**dadurch gekennzeichnet, dass**
die Computeranlagen in einem eigenen Schaltschrank oder Rack untergebracht sind.

3. Elektrische Einrichtung nach Anspruch 2,
**dadurch gekennzeichnet, dass**
die Schaltschränke bzw. Racks der Computeranlagen (9.1, 9.2) benachbart zu wenigstens einer Seitenwand (11.1, 11.2) des Gehäuses (1000) des Verdampfers (20) angeordnet sind.

4. Elektrische Einrichtung nach einem der Ansprüche 1 bis 3,
**dadurch gekennzeichnet, dass**
das Gehäuse des Verdampfers eine der stirnseitigen Seitenwand (13.1) gegenüberliegende Seitenwand (13.2) umfasst, über die gekühlte Luft in den Raum (5) abgegeben wird.

5. Elektrische Einrichtung nach Anspruch 4,
**dadurch gekennzeichnet, dass**
im Gehäuse eine Vielzahl von Lüftern (1002.1, 2002.2, 1002.3, 1002.4, 1002.5, 1002.6) hinter der stirnseitigen Seitenwand (13.1) gegenüberliegenden Seitenwand (13.2) zum Ansaugen der Luft angeordnet sind.

6. Elektrische Einrichtung
nach einem der Ansprüche 1 bis 5,
**dadurch gekennzeichnet, dass**
Kühleinrichtung wenigstens zwei Außengeräte (22.1, 22.2) umfasst, die je einem Kühlkreislauf zugeordnet ist.

7. Elektrische Einrichtung nach einem der Ansprüche 1 bis 6,
**dadurch gekennzeichnet, dass**
der Verflüssiger umfasst:
- einen Axialventilator, bevorzugt mit einer Korbgitterkonsole, insbesondere in korrosionsgeschützter, wasserfester Ausführung;
- einen Wärmetauscher, insbesondere mit Aluminiumlamellen, die bevorzugt aufgepresst sind;
- einen Drehzahlregler für den Axialventilator, bevorzugt gesteuert und angeordnet in der Kondensatleitung.

8. Elektrische Einrichtung nach einem der Ansprüche 1 bis 7,
**dadurch gekennzeichnet, dass**
die Kühleinrichtung wenigstens zwei elektronische Expansionsventile, bevorzugt mit Drucktransmitter und Temperaturfühler, umfasst.

9. Elektrische Einrichtung nach einem der Ansprüche 1 bis 8,
**dadurch gekennzeichnet, dass**
der Verdichter wenigstens zwei Scroll-Kompressoren umfasst.

10. Elektrische Einrichtung nach Anspruch 9,
**dadurch gekennzeichnet, dass**
der Scroll-Kompressor ein drehzahlgeregelter Verdichter zur Verdichtung eines Kältemittels ist.

11. Elektrische Einrichtung
nach einem der Ansprüche 1 bis 10,
**dadurch gekennzeichnet, dass**
die Kühleinrichtung eine Regel- und/oder Steuereinrichtung (200), bevorzugt einen Mikroprozessor umfasst.

12. Elektrische Einrichtung nach Anspruch 11,
**dadurch gekennzeichnet, dass**
die Regel- und/oder Steuereinrichtung (200) in Abhängigkeit eines oder mehrere der nachfolgenden Steuer-/Regel-Größen
- der Raumtemperatur im geschlossenen Raum
- der Außentemperatur außerhalb des geschlossenen Raumes
- dem Betriebszustand der Computeranlage, insbesondere der Stromaufnahme der Computeranlage, der Leistungsaufnahme der Computeranlage
eine oder mehrere der nachfolgenden Einrichtungen:
- das Gebläse
- den Verdampfer
- den Verdichter
- den Ventilator steuert und/oder regelt.

## Claims

1. An electrical device having two computer systems (9.1, 9.2) and having a cooling device, in particular a climate-control device, wherein the computer systems (9.1, 9.2) are housed in a closed or enclosed chamber (5) and the cooling device comprises at least one evaporator (20), preferably a side wall evaporator, a compressor, and a liquefier; and
the compressor and the liquefier are arranged outside the closed or enclosed chamber, preferably in an external appliance (22, 22.1, 22.2), **characterized in that**
- the cooling device has at least two separate, closed cooling loops having separate supply lines (24.1, 24.2) to the evaporator (20) and separate drain lines (26.1, 26.2) from the evaporator;
- the evaporator (20) is embodied in a redundant construction in a single housing (1000) and has a single evaporator block (1004) having separate piping systems (1100.1, 1100.2), resulting in a partial evaporator in each case, wherein each partial evaporator is associated with one of the two separate cooling loops in each case;
- the at least two partial evaporators are housed in one housing (1000), wherein openings are formed in the side walls (11.1, 11.2) of the housing (1000);
- wherein the evaporator (20) is arranged as a single standing evaporator between the two computer systems (9.1, 9.2) to be cooled and air is aspirated via an end-face side wall (13.1) of the housing (20), cooled in the evaporator (20), and conveyed via the openings and guiding units in the side walls to the respective computer system (9.1, 9.2).

2. The electrical device according to Claim 1,
**characterized in that** the computer systems are housed in a separate control cabinet or rack.

3. The electrical device according to Claim 2,
**characterized in that** the control cabinets or racks of the computer systems (9.1, 9.2) are arranged adjacent to at least one side wall (11.1, 11.2) of the housing (1000) of the evaporator (20).

4. The electrical device according to any one of Claims 1 to 3,
**characterized in that** the housing of the evaporator comprises a side wall (13.2) opposite to the end-face side wall (13.1), via which the cooled air is emitted into the chamber (5).

5. The electrical device according to Claim 4,
**characterized in that** a plurality of fans (1002.1, 2002.2, 1002.3, 1002.4, 1002.5, 1002.6) are arranged in the housing behind the side wall (13.2) opposite to the end-face side wall (13.1) for aspirating the air.

6. The electrical device according to any one of Claims 1 to 5,
**characterized in that** the cooling device comprises at least two external devices (22.1, 22.2), which are each associated with one cooling loop.

7. The electrical device according to any one of Claims 1 to 6,
**characterized in that** the liquefier comprises:
- an axial ventilator, preferably having a basket console, in particular in a corrosion-protected, waterproof embodiment;
- a heat exchanger, in particular having aluminum plates, which are preferably pressed on;
- a speed regulator for the axial ventilator, preferably controlled and arranged in the condensate line.

8. The electrical device according to any one of Claims 1 to 7,
**characterized in that** the cooling device comprises at least two electronic expansion valves, preferably having pressure transmitter and temperature sensor.

9. The electrical device according to any one of Claims 1 to 8,
**characterized in that** the compressor comprises at least two scroll compressors.

10. The electrical device according to Claim 9,
**characterized in that** the scroll compressor is a speed-regulated compressor for compressing a refrigerant.

11. The electrical device according to any one of Claims 1 to 10,
**characterized in that** the cooling device comprises a regulating and/or control unit (200), preferably a microprocessor.

12. The electrical device according to Claim 11,
**characterized in that** the regulating and/or control unit (200) controls and/or regulates one or more of the following devices:
- the fan
- the evaporator
- the compressor
- the ventilator
as a function of one or more of the following control/regulating variables
- the room temperature in the closed chamber
- the external temperature outside the closed chamber
- the operating state of the computer system, in particular the current consumption of the computer system or the power consumption of the computer syste

## Revendications

1. Dispositif électrique avec deux installations d'ordinateur (9.1, 9.2) et avec un dispositif de refroidissement, en particulier un dispositif de climatisation, dans lequel les installations d'ordinateur (9.1, 9.2) sont logées dans un espace (5) clos ou entouré et le dispositif de refroidissement comporte au moins un évaporateur (20), de préférence un évaporateur à échange sur les parois latérales, un compresseur et un condenseur, et
le compresseur et le condenseur sont disposés en dehors de l'espace clos ou entouré, de préférence dans un appareil externe (22, 22.1, 22.2), **caractérisé en ce que**
- le dispositif de refroidissement présente au moins deux circuits de refroidissement fermés séparés avec des conduites d'arrivée séparées (24.1, 24.2) vers l'évaporateur (20) et des conduites d'évacuation propres (26.1, 26.2) sortant de l'évaporateur ;
- l'évaporateur (20) est réalisé selon une construction redondante dans un seul boîtier propre (1000) et possède un seul bloc d'évaporateur (1004) avec des tuyauteries séparées (1100.1, 1100.2), formant chacune une partie d'évaporateur, chaque partie d'évaporateur étant associée à l'un des deux circuits de refroidissement séparés ;
- les au moins deux parties d'évaporateur sont logées dans un boîtier (1000), des ouvertures étant formées dans les parois latérales (11.1, 11.2) du boîtier (1000) ;
- l'évaporateur (20) étant disposé comme un évaporateur isolé entre les deux installations d'ordinateur (9.1, 9.2) à refroidir et de l'air étant aspiré à travers une paroi frontale (13.1) du boîtier (20), refroidi dans l'évaporateur (20) et acheminé par les ouvertures et des dispositifs de guidage dans les parois latérales jusqu'à l'installation d'ordinateur (9.1, 9.2) en question.

2. Dispositif électrique selon la revendication 1, **caractérisé en ce que** les installations d'ordinateur sont logées dans une armoire électrique ou un châssis propre.

3. Dispositif électrique selon la revendication 2, **caractérisé en ce que** les armoires électriques ou châssis des installations d'ordinateur (9.1, 9.2) sont disposés à proximité d'au moins une paroi latérale (11.1, 11.2) du boîtier (1000) de l'évaporateur (20).

4. Dispositif électrique selon l'une des revendications 1 à 3, **caractérisé en ce que** le boîtier de l'évaporateur comprend une paroi latérale (13.2) faisant face à la paroi latérale frontale (13.1), par laquelle l'air refroidi est libéré dans l'espace (5).

5. Dispositif électrique selon la revendication 4, **caractérisé en ce qu'**il est prévu dans le boîtier plusieurs ventilateurs (1002.1, 2002.2, 1002.3, 1002.4, 1002.5, 1002.6) disposés derrière la paroi latérale (13.2) faisant face à la paroi latérale frontale (13.1) pour aspirer de l'air.

6. Dispositif électrique selon l'une des revendications 1 à 5, **caractérisé en ce que** le dispositif de refroidissement comprend au moins deux appareils extérieurs (22.1, 22.2) associés chacun à un circuit de refroidissement.

7. Dispositif électrique selon l'une des revendications 1 à 6, **caractérisé en ce que** le condenseur comprend :
- un ventilateur axial, de préférence avec une console de grille, en particulier dans une construction protégée contre la corrosion et résistante à l'eau ;
- un échangeur de chaleur, en particulier à lamelles en aluminium, de préférence serties ;
- un régulateur de vitesse de rotation pour le ventilateur axial, de préférence contrôlé et disposé dans la conduite de condensat.

8. Dispositif électrique selon l'une des revendications 1 à 7, **caractérisé en ce que** le dispositif de refroidissement comprend au moins deux valves d'expansion électroniques, de préférence avec capteur de pression et sonde de température.

9. Dispositif électrique selon l'une des revendications 1 à 8, **caractérisé en ce que** le compresseur comprend au moins deux compresseurs à volute.

10. Dispositif électrique selon la revendication 9, **caractérisé en ce que** le compresseur à volute est un compresseur à vitesse de rotation régulée pour la compression d'un réfrigérant.

11. Dispositif électrique selon l'une des revendications 1 à 10, **caractérisé en ce que** le dispositif de refroidissement comprend un dispositif de régulation et/ou de contrôle (200), de préférence un microprocesseur.

12. Dispositif électrique selon la revendication 11, **caractérisé en ce que** le dispositif de régulation et/ou de contrôle (200) contrôle et/ou régule, en fonction d'une ou plusieurs des grandeurs de régulation ou de contrôle suivantes :
- température ambiante dans l'espace clos,
- température extérieure à l'extérieur de l'espace clos,
- état de fonctionnement de l'installation d'ordinateurs, en particulier courant absorbé par l'installation d'ordinateurs, puissance absorbée de l'installation d'ordinateurs,
un ou plusieurs des dispositifs suivants :
- la soufflerie,
- l'évaporateur,
- le compresseur,
- le ventilateur.
